# EUROPÄISCHE PATENTSCHRIFT

(11) **EP 2 228 908 B1**
(45) Veröffentlichungstag und Bekanntmachung des Hinweises auf die Patenterteilung: **08.11.2017**
(21) Anmeldenummer: 10002595.6
(22) Anmeldetag: 12.03.2010
(51) Int. Cl.: H03K 17/96, H03K 17/97

(54) **VERFAHREN ZUM BETREIBEN EINES PIEZO-SCHALTELEMENTS**
METHOD OF OPERATING A PIEZO SWITCHING ELEMENT
PROCÉDÉ DE FONCTIONNEMENT D'UN PIÉZO-COMMUTATEUR

(30) Priorität: 12.03.2009 DE 102009012475
(43) Veröffentlichungstag der Anmeldung: 15.09.2010
(73) Patentinhaber: Engelking Elektronik GmbH, 78609 Tuningen (DE)
(72) Erfinder: Von Knobloch, Robert, 78126 Königsfeld (DE)
(74) Vertreter: Westphal, Mussgnug & Partner Patentanwälte mbB

(56) Entgegenhaltungen:
- US-A- 5 170 087
- US-A- 5 216 316

## Beschreibung

Die Erfindung betrifft ein Verfahren zum Betreiben eines Piezo-Schaltelements.

Bei einem Piezo-Element wird der hierauf ausgeübte Druck ausgewertet und in Abhängigkeit der Auswertung eine Schaltfunktion ausgeübt.

Ein solches Piezo-Schaltelement ist aus der DE 43 32 927 C2 bekannt, bei dem ein Kontaktträger mit Gehäuseteilen umspritzt wird, wobei einer der Gehäuseteile als Träger für ein Piezo-Element und ein elektronisches Bauelement dient. Die über Kontaktträger verbundenen Gehäuseteilen werden zusammengefaltet und miteinander verrastet.

Ein derartiges Piezo-Schaltelement ist sehr aufwendig herzustellen und führt damit zu hohen Herstellkosten.

Aus der gleichen DE 43 32 927 C2 ist ein weiteres Piezo-Schaltelement bekannt, bei dem ein sockelartiger Kunststoffträger als Gehäuse dient und eine Leiterbahnen und Kontaktflächen aufweisende Trägerfolie sowohl das Piezo-Element als auch das elektronische Bauelement trägt und die derart bestückte Trägerfolie um den Kunststoffträger gefaltet wird.

Nachteilig bei diesem bekannten Piezo-Element ist die komplizierte und kritische Montage der bestückten Folie auf den Kunststoffträger.

Ferner sind diese bekannten Piezo-Schaltelemente relativ unempfindlich, da erst ein bestimmter Schwellwert, der durch den die Piezo-Signale verarbeitender Schaltkreis bestimmt wird, überschritten werden muss. Zudem wird durch die dort eingesetzten Schaltkreise das Piezo-Signal lediglich verstärkt und kann zu ungewollten Schaltvorgängen aufgrund von Hammerschlägen oder Vibrationen führen.

Aus der DE 10 2007 054 347 B3 ist ein Piezo-schalt-element bekannt, bei dem das Piezo-Element statt horizontal im Bereich einer ein Betätigungselement aufweisende Betätigungsfläche, vertikal im Bereich einer senkrecht zur Betätigungsfläche stehenden Seitenwand angeordnet ist. Zur Betätigung des Piezo-Elements ist an die einseitig schwenkbare Betätigungsfläche senkrecht ein Schenkel angeformt, über den die Betätigungskraft senkrecht zur Betätigungsfläche auf das Piezo-Element gelenkt wird.

Der Vollständigkeit halber wird auch auf die WO 2007/120042 verwiesen, die ein Piezo-Schaltelement beschreibt, dessen Piezo-Element von beabstandeten, auf gegenüberliegenden Seiten des Piezo-Elements angeordneten Schultern getragen bzw. abgestützt wird, wodurch die Belastungen des Piezo-Elements reduziert werden und die Lebensdauer sich erhöhen soll. Zur Bildung eines das Piezo-Element umschließenden Gehäuses wird das Piezo-Element unter Ausbildung eines Hohlraumes umspritzt, wobei in diesem Hohlraum die das Piezo-Element abstützenden Schultern sowie ein an einer Betätigungsfläche des Gehäuses angeformtes Betätigungselement ausgebildet sind.

Schließlich sind in US 5,216,316 A und US 5,170,087 A weitere Piezo-Schaltelemente beschrieben.

Das in US 5,216,316 A beschriebene Piezo-Schaltelement weist ein auf einem Träger angeordnetes Piezo-Element und wenigstens ein elektronisches Bauelement auf, wobei das Piezo-Element und das elektronische Bauelement, insbesondere ein Mikroprozessor, auf gegenüberliegenden Seiten des Trägers angeordnet sind. Es weist weiter auf:
- ein Gehäuse, das zur Aufnahme des als Leiterplatte ausgebildeten Trägers vorgesehen ist, wobei
- das Gehäuse zylinderförmig mit einem stirnseitigen Bodenteil als Betätigungsabschnitt ausgebildet ist, wobei der Betätigungsabschnitt ein Kontaktierelement aufweist, wobei
- der Träger mit dem Piezo-Element im Bereich des Bodenteils angeordnet ist, und wobei
- der Betätigungsabschnitt derart federnd ausgebildet ist, dass eine auf den Betätigungsabschnitt des Gehäuses (5) ausgeübte externe Kraft durch das Kontaktierelement auf das Piezo-Element zum Erzeugen eines dieser Kraft entsprechenden Signals geleitet wird.

Durch die derart in das Gehäuse eingebrachte Struktur kann ein definierter Druckpunkt realisiert werden, so dass dadurch eine sehr hohe Empfindlichkeit erreicht werden kann.

Die Erfindung hat das Ziel, ein Verfahren zum Betreiben eines solchen Piezo-Schaltelements anzugeben, mit dem dessen vorteilhafte Eigenschaften zur Geltung kommen, insbesondere ungewollte Schaltvorgänge weitestgehend ausgeschlossen werden können.

Das Ziel wird erreicht durch ein Verfahren zum Betreiben des Piezo-Schaltelements mit den Merkmalen des Patentanspruchs 1.

Hiernach umfasst dieses Verfahren zum Betreiben eines solchen Piezo-Schaltelements, bei dem das elektronische Bauelement, vorzugsweise ein Mikroprozessor, in Abhängigkeit des Piezo-Signals ein einen Schaltvorgang auslösendes Steuersignal erzeugt, folgende Verfahrensschritte:
a) Detektieren eines Drucksignal mittels des Piezo-Elements,
b) Auswerten des Piezo-Signals hinsichtlich dessen Zeit-Pegel-Verlaufs auf der Basis vorgegebener Parameter,
c) Bestimmen eines das Piezo-Signal auslösenden Druckgebers auf das Piezo-Element in Abhängigkeit des Auswerteergebnisses,
d) Erzeugen eines Steuersignals in Abhängigkeit des bestimmten Druckgebers, wobei nur für zugelassene Druckgeber ein Steuersignal erzeugt wird, wobei für verschiedene Druckgeber unterschiedliche Steuersignale erzeugt werden. und
e) Durchführen des Verfahrensschrittes a).
Damit ist es möglich, aufgrund der hohen Sensibilität des Piezo-Schaltelements die Drucksignale hinsichtlich der Verläufe von vorbestimmten Druckimpulsen auszuwerten und damit verschiedene Druckgeber zu differenzieren. Das heißt, es kann zwischen unterschiedlichen signalgebenden Ereignissen unterschieden werden, dies betrifft bspw. die Auslösung eines Drucksignals durch den Finger eines Benutzers, durch Hammerschlag, Stöße, Hiebe oder Schläge auf den Betätigungsabschnitt sowie auch die Auslösung eines Drucksignals durch Vibrationen. Infolgedessen kann auch auf solche unterschiedliche signalauslösende Ereignisse differenziert reagiert werden. So wird nur für zugelassene Druckgeber ein Steuersignal erzeugt, d. h. bspw. ein identifizierter Hammerschlag wird ignoriert und kein Steuersignal erzeugt. Erfindungsgemäß werden also für verschiedene zugelassene Druckgeber unterschiedliche Steuersignale erzeugt, wodurch auch entsprechende unterschiedliche Schaltvorgänge ausgelöst werden können. So kann bspw. auf einen Hammerschlag im Vergleich zu einer Fingerbetätigung in besonderer Weise reagiert werden, in dem bspw. ein Steuersignal erzeugt wird, das einen gesonderten Schaltvorgang auslöst. Mit einem solchen Schaltvorgang kann bspw. eine Warneinrichtung angesteuert werden.

So kann in einer Weiterbildung der Erfindung ein solcher Schaltvorgang, der durch einen solchen detektierten "Hammerschlag" ausgelöst wurde, in einem Speicher gespeichert werden, der im Rahmen einer Inspektion oder Prüfung des Piezo-Tasters ausgelesen werden.

Die Erfindung wird nachfolgend anhand eines Ausführungsbeispiels unter Bezugnahme auf die beigefügten Figuren ausführlich beschrieben. Es zeigen:
- Figur 1: eine Querschnittsdarstellung eines Piezo-Schaltelements verwendet in einer Ausführungsform der Erfindung,
- Figur 2: eine Draufsicht in das Innere des Gehäuses des Piezo-Schaltelements nach Figur 1,
- Figur 3: ein Blockschaltbild der Funktionseinheiten eines in der Erfindung verwendeten Piezo-Schalters, und
- Figur 4: ein Ablaufdiagramm zur Darstellung der Betriebsweise eines erfindungsgemäßen Piezo-Schalters.

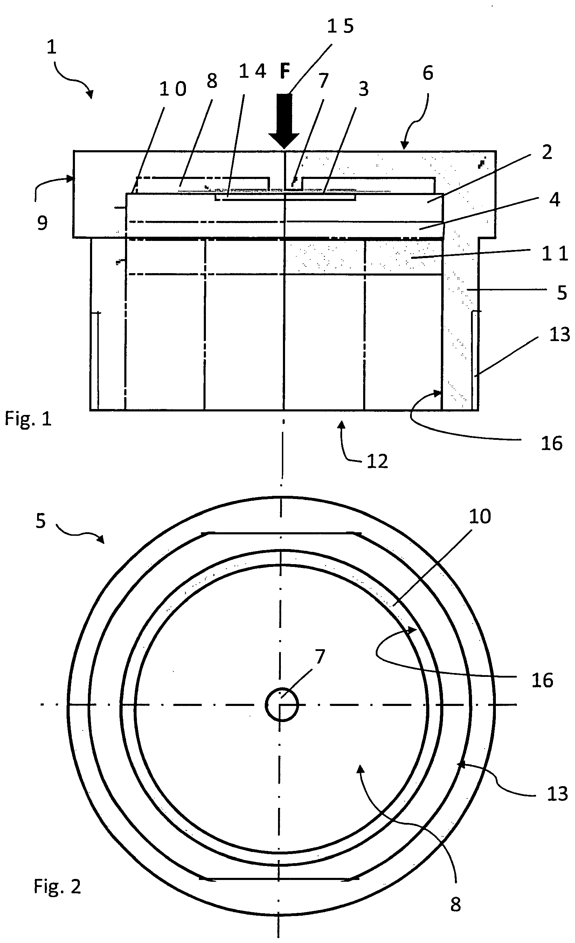

In der Schnittdarstellung nach Figur 1 ist ein Piezo-Schaltelement 1 mit einem zylinderförmigen Gehäuse 5 dargestellt, welches ein auf einer Leiterplatte 2 angeordnetes Piezo-Element 3 aufnimmt. Dieses zylinderförmige Gehäuse 5 wird an einer seiner Stirnseite von einem Bodenteil 9 verschlossen, während es auf der gegenüberliegenden Stirnseite offen ist. Die zylindrische Umfangsfläche dieses Bodenteils 9 weist einen größeren Durchmesser auf, als die daran sich anschließende Mantelfläche des Gehäuses 5. Ausgehend von der offenen Stirnseite des Gehäuses 5 trägt diese Mantelfläche ein Gewinde 13, so dass das Piezo-Schaltelement 1 in eine nicht dargestellte Montagefläche ggf. bis an den dabei als Anschlag dienenden Bodenteil 9 einschraubbar ist.

Ausgehend von der offenen Stirnseite 12 des Gehäuses 5 erstreckt sich dessen zylindrische Innenfläche 16 bis in den Bereich des Bodenteils 9, wo sich unter Ausbildung einer ringförmigen Schulter 10 ein zylindrischer Hohlraum 8 mit kleinerem Durchmesser anschließt, dessen Bodenfläche eine Betätigungsfläche 6 als Teil des Bodenteils 9 bildet. Nach Figur 2 ist in der Draufsicht auf die offene Stirnseite 12 des Gehäuses 5 dessen leerer Innenraum mit der Innenfläche 16, der kreisringförmig umlaufenden Schulter 10, die in die Bodenfläche des Hohlraums 8 übergeht, neben einem zylindrischen Kontaktierelement 7, dessen Funktion weiter unter erläutert wird, gut zu erkennen.

Die Leiterplatte 2 liegt auf dieser Schulter 10 an, und ist zur Anpassung an die zylindrische Innenfläche 16 des Gehäuses 5 kreisförmig derart ausgebildet, dass die Leiterplatte 2 mit ihrer umlaufenden Stirnfläche an der zylindrischen Innenfläche 16 des Gehäuses 5 anliegt.

Auf der zur Betätigungsfläche 6 benachbarten Seite der Leiterplatte 2 ist zentral das als Piezo-Scheibe ausgebildete Piezo-Element 3 angeordnet, wobei im Bereich des Piezo-Elements 3 die Leiterplatte 2 einen Hohlraum 14 derart aufweist, dass das Piezo-Element 3 nur mit seinem Rand auf der Leiterplatte 2 aufliegt und dadurch eine Durchbiegen der Piezo-Scheibe in diesen Hohlraum 14 möglich ist. Mittels auf der Leiterplatte 2 angeordnete Kontaktflächen ist das Piezo-Element 3 direkt aufgelötet.

Dem zentralen Bereich der Piezo-Scheibe 3 steht ein Kontaktierelement 7 gegenüber, welches axial hinsichtlich der Symmetrieachse X des Gehäuses 5, wie auch aus Figur 2 ersichtlich, angeordnet und sockelförmig sowie formschlüssig, insbesondere einstückig mit dem Betätigungsabschnitt 6 des Bodenteils 9 ausgebildet ist. Die radiale Ausdehnung dieses Kontaktierelements 7 ist klein gegenüber dem Durchmesser des Hohlraumes 8.

Die Wandstärke des Betätigungsabschnittes 6 ist derart federnd ausgebildet, dass bei einer von außen zentral ausgeübten Kraft F entsprechend des Richtungspfeils 15 diese Kraft F ein Auslenken des Betätigungsabschnittes 6 zusammen mit dem Kontaktierelement 7 in Richtung des Piezo-Elements 3 bewirkt und dadurch das Kontaktierelement 7 einen entsprechendem Druck auf die Piezo-Scheibe 3 ausübt, so dass auch diese Piezo-Scheibe 3 in den dahinterliegenden Hohlraum 14 ausgelenkt wird und dabei in Abhängigkeit des Druckes ein Spannungssignal erzeugt. Mit einem derart strukturierten Bodenteil 9 zur Ausbildung eines Betätigungsabschnitts 6 wird ein definierter Druckpunkt ins Zentrum der Piezo-Scheibe 3 sichergestellt.

Dieses Spannungssignal wird über entsprechende Leitungen auf der Leiterplatte 2 auf deren gegenüberliegende Seite geführt, auf der elektronische Bauelemente 4 als Chip angeordnet sind, vorzugsweise ein Mikroprozessor. Diese Seite der Leiterplatte 2 wird mit einer Vergussmasse 11 formschlüssig mit der Innenfläche 16 des Gehäuses 5 vergossen bzw. abgedeckt, so dass damit gleichzeitig ein luft- und feuchtigkeitsdichter Verschluss der offenen Stirnseite 12 des Gehäuses 5 erzielt wird.

Mit einem Mikroprozessor als elektronisches Bauelement 4 auf der Leiterplatte 2 kann dieses Piezo-Schaltelement 1 als intelligenter Piezo-Taster verwendet werden, indem die von dem Piezo-Element erzeugten Spannungssignale derart ausgewertet werden, dass nur vorbestimmte Druckimpulse als Schaltimpulse erkannt werden, um damit beispielsweise Hammerschläge oder sonstige unabsichtlich ausgeübte Schläge auf den Betätigungsabschnitt 6 ignorieren oder hierfür gesonderte Schaltvorgänge auslösen zu können. Damit kann zwischen unterschiedlichen Druckgebern, also beispielsweise ob die ausgeübten Kräfte von dem Finger eines Bedieners oder von einem Hammer herrühren, unterschieden werden. Auch kann damit ausgeschlossen werden, dass Vibrationen einen Schaltvorgang auslösen.

Wird ein vorbestimmtes Spannungssignal erkannt, wird der eigentliche Schaltvorgang über eine entsprechende Ansteuerschaltung, die ebenfalls als elektronisches Bauelement auf der Leiterplatte 2 angeordnet sein kann, ausgelöst. Der Schaltvorgang kann öffnend, schließend, digital, seriell oder analog sein, wobei der geschlossene oder geöffnete Kontakt für eine bestimmte Zeitdauer oder dauerhaft bis zum nächsten Betätigen beibehalten werden kann.

Zusätzlich können in dem Gehäuse 5 oder in einer Montagefläche, in der das Gehäuse eingeschraubt wird, LED's integriert werden, die einem Benutzer eine Rückmeldung geben und ebenfalls von einer auf der Leiterplatte 2 angeordneten Ansteuerschaltung unabhängig vom Schaltvorgang angesteuert werden können.

Das Piezo-Schaltelement nach den Figuren 1 und 2 ist mit einem kreiszylinderförmigen Gehäuse ausgebildet. Ebenso kann ein Gehäuse mit anderen Querschnittsformen, beispielsweise mit einem rechteckigen oder quadratischen Querschnitt ausgeführt werden, vorstellbar sind auch Querschnitte mit regelmäßigen geometrischen Figuren, wie beispielsweise ein Dreieck.

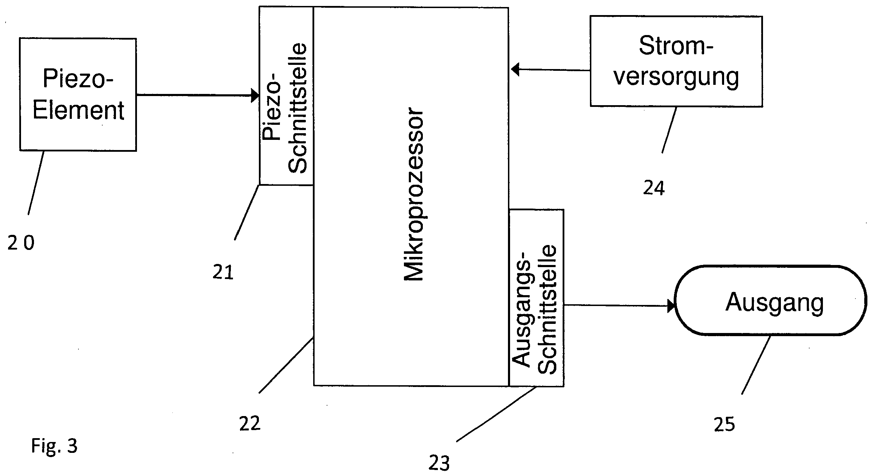

Das Blockschaltbild nach Figur 3 zeigt die einzelnen Funktionseinheiten eines Piezo-Schalters. Hiernach wird das von einem Piezo-Element als Funktionseinheit 20 ein Piezosignal an die eine Piezo-Schnittstelle 21 eines Mikroprozessors 22 geleitet. Diese Piezo-Schnittstelle 21 dient zur elektrischen Anpassung der von einem Piezo-Element erzeugten Spannungssignale an den Mikroprozessor 22. Dieser Mikroprozessor 22 umfasst einen Analog/Digitalwandler zur Umsetzung der analogen Spannungssignale des Piezo-Elements in entsprechende digitale Signale, einen Programmspeicher für ein Ablaufprogramm, einen Speicher, vorzugsweise ein EEPROM zur Speicherung von Parametersätzen sowie einen Ausgang, an den eine Ausgangsschnittstelle 23 angeschlossen ist, die eine elektrische Anpassung an die an deren Ausgang 25 anzuschließende Funktionseinheiten vornimmt. Dies können sowohl Transistorschalter, insbesondere auch Tristate-Schalter, als auch Bussysteme (seriell oder parallel) sein.

Zur Stromversorgung des Mikroprozessors 22 ist eine Stromversorgungseinheit 24 mit ESD/EMV-Schutz vorgesehen.

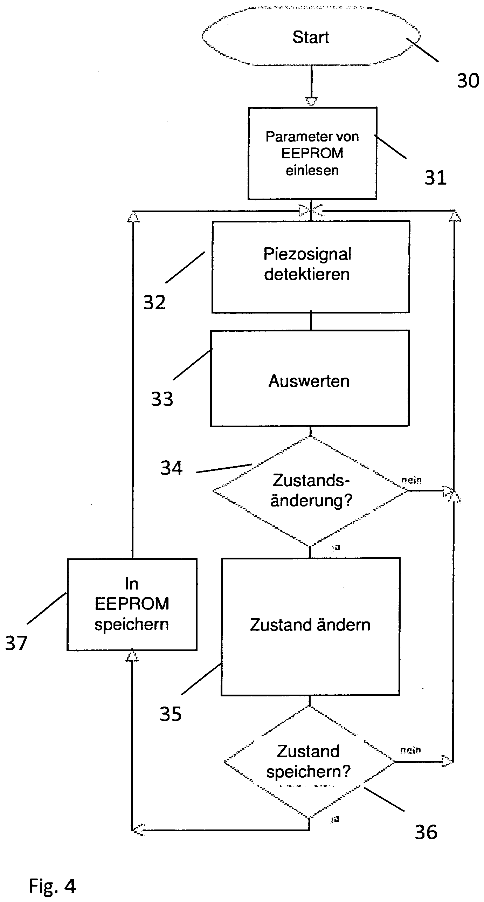

Mit Figur 4 wird im Folgenden die Betriebsweise eines Piezo-Schalters mit den in Figur 3 beschriebenen Funktionseinheiten erläutert. In einem ersten Schritt 30 wird das System gestartet, d. h. der Betriebsstrom zur Verfügung gestellt und die Hardware initialisiert. In einem weiteren Schritt 31 werden Parametersätze aus einem EEPROM-Speicher in den Arbeitsspeicher des Mikroprozessors geladen, die dazu dienen, die detektierten Piezo-Signale nach Schritt 32 auszuwerten. Die Parametersätze beziehen sich auf die Spannungspegel des Piezosignals sowie auf die zeitlichen Verläufe dieser Spannungspegel. Im Schritt 33 wird mittels dieser Parametersätze ermittelt, durch welches Ereignis das detektierte Piezo-signal ausgelöst wurde, ob also eine Fingerbetätigung vorliegt, oder ob ein Hammerschlag, Stöße, Hiebe oder Schläge das auslösende Ereignis war.

So kann bspw. bei einer Bestimmung eines Hammerschlages dieses Ereignis ignoriert werden, womit kein Steuersignal erzeugt wird, um bspw. den Zustand eines am Ausgang 25 angeschlossenen Schalters zu ändern. In diesem Fall würde ein Rücksprung auf Schritt 32 erfolgen.

Liegt jedoch der Regelfall vor, d. h. es wurde eine Fingerbetätigung bestimmt, erfolgt eine Zustandsänderung in Schritt 35 durch Erzeugen eines Steuersignals, das über den Ausgang 25 eine Änderung des Schaltzustands bspw. eines Transistorschalters bewirkt. In Schritt 36 wird geprüft, ob diese Zustandsänderung in Abhängigkeit der Parameter in einem EEPROM-Ringpuffer gemäß einem nachfolgenden Schritt 37 gespeichert werden soll. Im genannten Regelfall wird dies nicht erfolgen, so dass nach Schritt 36 ein Rücksprung auf Schritt 32 erfolgt.

Eine Zustandsänderung kann auch dann erforderlich sein, wenn als auslösendes Ereignis für eine Piezosignäl ein Hammerschlag bestimmt wurde und dieses Ereignis nicht ignoriert werden soll. So wird in diesem Fall nach Schritt 34 eine Steuersignal erzeugt, das am Ausgang 25 einen Schaltvorgang auslöst, der sich von dem Fall, der von einer Fingerbetätigung ausgelöst wird, unterscheidet. Das kann bspw. ein Alarm- oder Anzeigesignal oder einen sonstigen Schaltvorgang, bspw. unter Verwendung eines Tristate-Schalters auslösen. Ferner ist es in diesem Fall von Vorteil, diese Zustandsänderung gemäß Schritt 37 zu speichern, bevor wieder ein Rücksprung auf Schritt 31 erfolgt. Somit kann später nachvollzogen werden, bspw. im Rahmen einer Inspektion oder Reparatur, ob solche unerwünschten Ereignisse, wie Hammerschläge, Vibrationen, Stöße, Hiebe oder ähnliche Ereignisse stattgefunden haben.

### Bezugszeichenliste

- 1: Piezo-Schaltelement
- 2: Träger
- 3: Piezo-Element
- 4: elektronische Bauelemente
- 5: Gehäuse
- 6: Betätigungsabschnitt des Gehäuses 5
- 7: Kontaktierelement
- 8: Hohlraum
- 9: Bodenteil

- 10: Absatz
- 11: Vergussmasse
- 12: Öffnung an der Stirnseite des Gehäuses 5
- 13: Gewinde
- 14: Hohlraum im Träger 2
- 15: Richtungspfeil
- 16: Innenfläche des Gehäuses 5

- 20: Funktionseinheit Piezo-Element
- 21: Piezo-Schnittstelle
- 22: Mikroprozessor
- 23: Ausgangsschnittstelle
- 24: Stromversorgungseinheit
- 25: Ausgangseinheit

- 30-37: Verfahrensschritte

## Patentansprüche

1. Verfahren zum Betreiben eines Piezo-Schaltelements, bei dem wenigstens ein elektronisches Bauelement (4) in Abhängigkeit eines Piezo-Signals ein einen Schaltvorgang auslösendes Steuersignal erzeugt, und wobei das Piezo-Schaltelement (1) mit einem auf einem Träger (2) angeordneten Piezo-Element (3) und dem wenigstens einen elektronischen Bauelement (4) ausgestattet ist, wobei das Piezo-Element (3) und das elektronische Bauelement (4) auf gegenüberliegenden Seiten des Trägers angeordnet sind,
ein Gehäuse (5) zur Aufnahme des als Leiterplatte ausgebildeten Trägers (2) vorgesehen ist,
das Gehäuse (5) zylinderförmig mit einem stirnseitigen Bodenteil (9) als Betätigungsabschnitt (6) ausgebildet ist, wobei der Betätigungsabschnitt (6) ein Kontaktierelement aufweist,
der Träger (2) mit dem Piezo-Element (3) im Bereich des Bodenteils (9) angeordnet ist, und
der Betätigungsabschnitt (6) derart federnd ausgebildet ist, dass eine auf den Betätigungsabschnitt (6) des Gehäuses (5) ausgeübte externe Kraft (F) durch das Kontaktierelement (7) auf das Piezo-Element (3) zum Erzeugen eines dieser Kraft (F) entsprechenden Signals geleitet wird, wobei folgende Verfahrensschritte vorgesehen sind:
a) Detektieren eines Drucksignals mittels des Piezo-Elements,
b) Auswerten des Piezo-Signals hinsichtlich dessen Zeit-Pegel-Verlaufs auf der Basis vorgegebener Parameter,
c) Bestimmen eines das Piezo-Signal auslösenden Druckgebers auf das Piezo-Element in Abhängigkeit des Auswerteergebnisses,
d) Erzeugen eines Steuersignals in Abhängigkeit des bestimmten Druckgebers, wobei nur für zugelassene Druckgeber ein Steuersignal erzeugt wird, wobei für verschiedene Druckgeber unterschiedliche Steuersignale erzeugt werden und
e) Durchführen des Verfahrensschrittes a).

2. Verfahren nach Anspruch 1, bei dem im Anschluss an Verfahrensschritt d) folgende Verfahrensschritte ausgeführt werden:
g) Bestimmen anhand der vorgegebenen Parameter, ob der durch das Steuersignal erreichte Schaltzustand zu speichern ist, und
h) in Abhängigkeit der Bestimmung nach Verfahrensschritt
g) entweder Speicherung des durch das Steuersignal erreichten Schaltzustands und anschließend Verfahrensschritt a) durchführen oder ohne Speicherung des durch das Steuersignal erreichten Schaltzustands Verfahrensschritt a) durchführen.

## Claims

1. A method for operating a piezo switching element, wherein at least one electronic component (4) generates, as a function of a piezo signal, a control signal triggering a switching operation, and wherein the piezo switching element (1) is equipped with a piezo element (3) disposed on a substrate (2) and the at least one electronic component (4), wherein the piezo element (3) and the electronic component (4) are disposed on opposite sides of the substrate,
a housing (4) for receiving the substrate (2) formed as a printed circuit board is provided,
the housing (5) is formed to be cylindrical with an front-side bottom part (9) as an actuation portion (6), which actuation portion (6) has a contacting element,
the substrate (2) with the piezo element (3) is disposed in the area of the bottom part (9), and
the actuation portion (6) is elastically formed in such a way that an external force (F) exerted on the actuation portion (6) of the housing (5) is transmitted through the contacting element (7) onto the piezo element (3) for generating a signal corresponding to said force (F), wherein the following method steps are provided:
(a) detecting a pressure signal by means of the piezo element,
(b) evaluating the piezo signal with regard to the time-level profile on the basis of specified parameters,
(c) designating a pressure transmitter onto the piezo element, which triggers the piezo signal, as a function of the evaluation result,
(d) generating a control signal as a function of the designated pressure transmitter, with a control signal being generated only for approved pressure transmitters, wherein different control signals are generated for different pressure transmitters, and
(e) carrying out method step (a).

2. The method as claimed in claim 1, wherein subsequent to method step (d), the following method steps are carried out:
(g) determining using the specified parameters whether the switching state reached by the control signal is to be stored, and
(h) depending on the determination after method step (g), either storing the switching state reached by the control signal and subsequently carrying out method step (a) or carrying out method step (a) without storing the switching state reached by the control signal.

## Revendications

1. Procédé de gestion d'un élément de commutation piézoélectrique selon lequel au moins un composant électronique (4) délivre en fonction d'un signal piézoélectrique un signal de commande déclenchant un processus de commutation, l'élément de commutation piézoélectrique (1) est équipé d'un élément piézoélectrique (3) monté sur un support (2) et du composant électronique (4), l'élément piézoélectrique (3) et le composant électronique (4) sont montés sur des faces opposées du support,
- il est prévu un boîtier (5) de réception du support (2) qui est réalisé sous la forme d'une plaquette de circuit imprimé,
- le boîtier (5) a la forme d'un cylindre comportant une partie de base frontale (9) constituant un segment d'actionnement (6), comprenant un élément de mise en contact,
- le support (2) équipé de l'élément piézoélectrique (3) est monté dans la zone de la partie de base (9), et
- le segment d'actionnement (6) du boîtier (5) est réalisé élastiquement de sorte qu'une force externe (F) exercée sur ce segment d'actionnement (6) soit transmise à l'élément piézoélectrique (3) par l'élément de mise en contact (7) pour délivrer un signal correspondant à cette force (F), procédé selon lequel on met en oeuvre les étapes suivantes consistant à :
a) détecter un signal de pression au moyen de l'élément piézoélectrique,
b) évaluer le signal piézoélectrique concernant les variations de son niveau en fonction du temps à partir de paramètres prédéfinis,
c) déterminer un capteur de pression sur l'élément piézoélectrique déclenchant le signal piézoélectrique en fonction du résultat de l'évaluation,
d) délivrer un signal de commande en fonction du capteur de pression déterminé, un signal de commande n'étant délivré que pour des capteurs de pression autorisés, et pour différents capteurs de pression, différents signaux de commande étant délivrés, et
e) mettre en oeuvre l'étape a).

2. Procédé conforme à la revendication 1,
**caractérisé en ce qu'**
après l'étape d), on met en oeuvre les étapes suivantes consistant à :
g) déterminer sur le fondement du paramètre prédéfini si l'état de commutation atteint par le signal de commande doit être enregistré, et
h) en fonction de la détermination après l'étape g), soit enregistrer l'état de commutation atteint par le signal de commande puis mettre en oeuvre l'étape a), ou, sans enregistrer l'état de commutation atteint par le signal de commande, mettre en oeuvre l'étape a).
